# EUROPEAN PATENT APPLICATION

(11) **EP 4 386 953 A1**
(43) Date of publication of application: **19.06.2024**
(21) Application number: 23204998.1
(22) Date of filing: 20.10.2023
(51) Int. Cl.: H01M 50/209, H01M 50/258, H01M 50/30, H01M 50/35

(54) **BATTERY MODULE AND ENERGY STORAGE SYSTEM INCLUDING THE SAME**

(30) Priority: 13.12.2022 KR 20220173910
(71) Applicant: SK On Co., Ltd., Seoul 03161 (KR)
(72) Inventor: PARK, Chan Ho, 34124 Daejeon (KR); GOO, Bon A, 34124 Daejeon (KR); PARK, Byung Jun, 34124 Daejeon (KR); JUNG, Jae Won, 34124 Daejeon (KR)
(74) Representative: Prüfer & Partner mbB Patentanwälte · Rechtsanwälte

(57) **Abstract**

An energy storage system (1) is disclosed. In an embodiment, the energy storage system (1) includes a battery module (10) including at least one battery cell, and a battery enclosure (30) structured to accommodate the battery module (10). The battery module (10) includes a case structured to include a first case (110; 210) forming a side of the battery module (10). The first case (110; 210) includes a first case body (111; 211) forming the side of the battery module, and a vent portion (112; 212) formed in the first case body (110; 210). The battery enclosure (30) includes an enclosure frame (31) structured to accommodate the battery module (10), and a wall assembly (32) forming a wall of the battery enclosure (30) and coupled to the enclosure frame (31). The wall assembly (32) includes a duct module (330) including a duct (331) coupled to the first case (110; 210) and structured to communicate with the vent portion (112; 212).

## Description

### TECHNICAL FIELD

The disclosed technology relates to a battery module and an energy storage system. disclosed technology

### BACKGROUND

Secondary batteries used in an energy storage system (ESS) include battery cells that are grouped together into a battery module. Damaged or unstable battery cells and improper charging can cause the battery cells to overheat, leading to an explosion or fire.

(Patent Document 1) US 8512887 B2

### SUMMARY

The disclosed technology can be implemented in some embodiments to provide an enclosure discharging foreign substances to the outside and an energy storage system including the same.

In one aspect of the disclosed technology, a battery module may include a plurality of sub-battery modules arranged in a direction between forward and rearward sides of the battery module, wherein each of the plurality of sub-battery modules includes at least one battery cell, and a sub-module case structured to accommodate the at least one battery cell, the sub-module case including a sub-vent case forming a side of the sub-module case, wherein the sub-module case includes a sub-vent case body forming the side of the sub-module case, and a sub-vent hole formed in the sub-vent case body and structured to communicate with an inside and an outside of the sub-module case.

In another aspect of the disclosed technology, a battery enclosure may include an enclosure frame structured to include an accommodation space, and a wall assembly coupled to the enclosure frame and structured to form a wall of the battery enclosure, wherein the wall assembly includes an inner wall forming an inner surface of the wall assembly and coupled to the enclosure frame, an outer wall forming an outer surface of the wall assembly and coupled to the enclosure frame, and a duct module coupled to the inner wall and including a duct protruding toward the accommodation space.

In another aspect of the disclosed technology, an energy storage system may include a battery module including at least one battery cell, and a battery enclosure structured to accommodate the battery module, wherein the battery module includes a case structured to include a first case forming a side of the battery module, wherein the first case includes a first case body forming the side of the battery module and a vent portion formed in the first case body, wherein the battery enclosure includes an enclosure frame structured to accommodate the battery module, and a wall assembly forming a wall of the battery enclosure and coupled to the enclosure frame, wherein the wall assembly includes a duct module including a duct structured to communicate with the vent portion and coupled to the first case.

In an embodiment of the disclosed technology, an enclosure discharging foreign substances to the outside and an energy storage system including the same can be provided.

### BRIEF DESCRIPTION OF THE DRAWINGS

The accompanying drawings illustrate examples of embodiments of various technical features disclosed in the disclosure.
FIG. 1 illustrates an example of an energy storage system based on an embodiment of the disclosed technology.
FIG. 2 illustrates an example of a battery module based on an embodiment of the disclosed technology.
FIG. 3 is an exploded perspective view illustrating an example of a module case of a battery module illustrated in FIG. 2.
FIG. 4A is a cross-sectional view of a vent case taken along B1-B2 of FIG. 3 and illustrates a protruding duct coupling part.
FIG. 4B is a cross-sectional view of a vent case taken along B1-B2 of FIG. 3 and illustrates a concave duct coupling part.
FIG. 5 illustrates an example of a battery module including a plurality of sub-battery modules based on an embodiment of the disclosed technology.
FIG. 6 illustrates an example of a sub-battery module.
FIG. 7 illustrates a portion of a sub-battery module illustrated in FIG. 6.
FIG. 8 illustrates an example of a battery enclosure based on an embodiment of the disclosed technology.
FIG. 9 illustrates an example of a battery module loaded into an enclosure.
FIGS. 10 and 11 illustrate a duct module based on an embodiment of the disclosed technology when viewed at different angles.
FIG. 12 illustrates an example of a duct module coupled to an inner wall.
FIG. 13 illustrates an example of a duct module coupled to a battery module.
FIG. 14 is a cross-sectional view of a duct module and a battery module taken along C 1-C2 of FIG. 13.
FIG. 15 is a cross-sectional view of an energy storage system taken along A1-A2 of FIG. 1.

### DETAILED DESCRIPTION

Reference will now be made in detail to embodiments of the disclosed technology, examples of which are illustrated in the accompanying drawings. However, the following description is merely an example and does not intended to limit the disclosed technology to a specific implementation.

When an explosion or fire occurs in a damaged battery module or an energy storage system including the damaged battery module, substances such as conductive materials may spread from the damaged battery to other battery module. The disclosed technology can be implemented in some embodiments to provide a battery module in an energy storage system that can easily discharge substances from the battery module to the outside of the energy storage system.

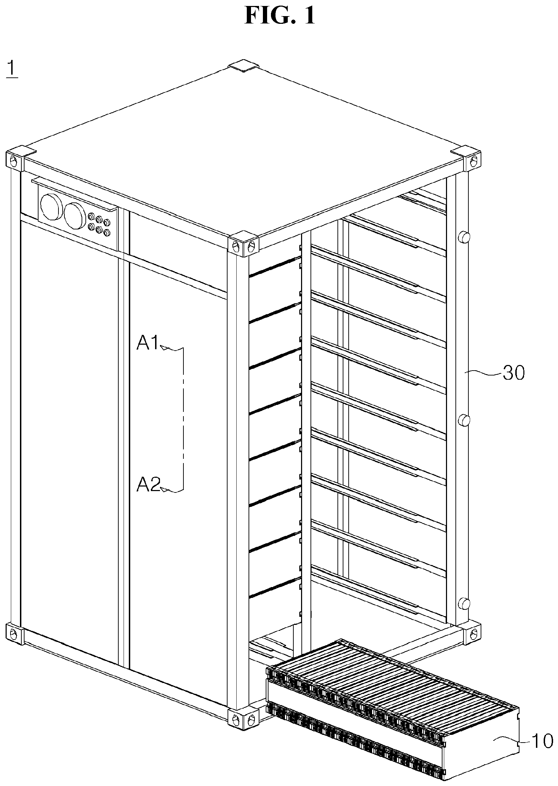

FIG. 1 illustrates an example of an energy storage system based on an embodiment of the disclosed technology.

Referring to FIG. 1, an energy storage system 1 may include a battery module 10. The energy storage system 1 may be referred to as an energy storage system (ESS). For convenience of description, the energy storage system 1 in which a front portion of an enclosure 30 is removed may be illustrated in FIG. 1. In some implementations, the term "enclosure" can be used to indicate an enclosure of a device such as a battery enclosure.

In some implementations, the energy storage system 1 may include a plurality of battery modules 10. Each of the battery modules 10 may perform charging and discharging. When the battery module 10 is charged, the battery module 10 may receive power or energy from an external power grid or an external device. When the battery module 10 is discharged, the battery module 10 may provide power or energy to the external power grid or the external device.

The energy storage system 1 may include the enclosure 30. The enclosure 30 may accommodate at least one battery module 10. The enclosure 30 may form an accommodation space into which at least one battery module 10 is loaded.

When a fire occurs in the battery module 10 in the accommodation space of the enclosure 30, flame or gas or scattering powder may spread in the accommodation space of the enclosure 30. In this case, it may be difficult to extinguish the fire of the battery module 10, and in particular, an additional fire may occur in the battery module 10. The disclosed technology can be implemented in some embodiments, when a fire occurs in the battery module 10, to prevent substances generated by the fire from spreading to the accommodation space of the enclosure 30.

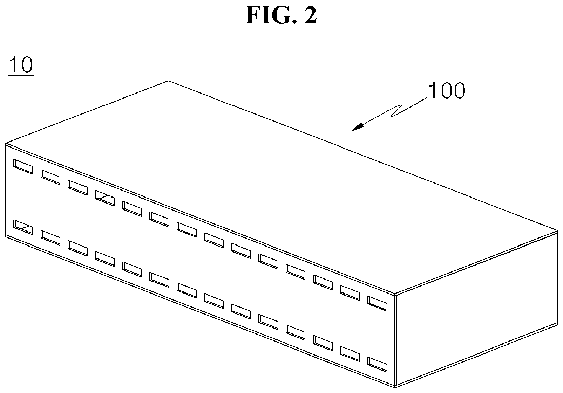

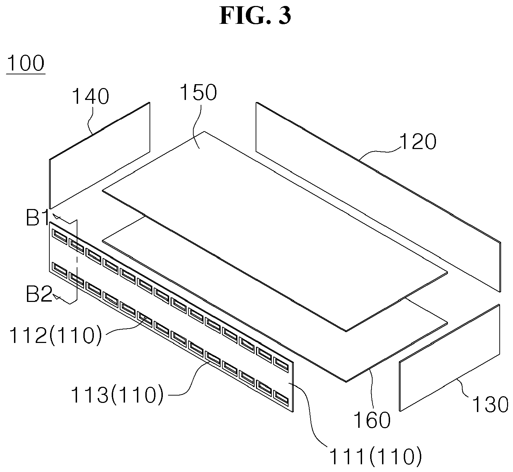

FIG. 2 illustrates an example of a battery module based on an embodiment of the disclosed technology. FIG. 3 is an exploded perspective view illustrating an example of a module case of a battery module illustrated in FIG. 2.

Referring to FIGS. 2 and 3, the battery module 10 may include a module case 100. The module case 100 may form an exterior appearance of the battery module 10. The module case 100 may form a hexahedral shape as a whole.

The module case 100 may accommodate at least one battery cell (not shown). The at least one battery cell (not shown) may be a secondary battery capable of charging and discharging. In some implementations, the module case 100 may accommodate a plurality of battery cells (not shown) electrically connected to each other.

The module case 100 may include a bottom case 160. The bottom case 160 may be positioned below at least one battery cell (not shown). The bottom case 160 may load at least one battery cell (not shown). The bottom case 160 may form a bottom surface of the module case 100.

The module case 100 may include a top case 150. The top case 150 may be positioned over the bottom case 160. The top case 150 may be positioned on at least one battery cell (not shown). At least one battery cell (not shown) may be positioned between the bottom case 160 and the top case 150. The top case 150 may form an upper surface of the module case 100.

The module case 100 may include a front case 130. The front case 130 may form a front face of the module case 100. A lower end of the front case 130 may be coupled to a front end of the bottom case 160. An upper end of the front case 130 may be coupled to a front end of the top case 150.

The module case 100 may include a rear case 140. The rear case 140 may form a rear face of the module case 100. A lower end of the rear case 140 may be coupled to a rear end of the bottom case 160. An upper end of the rear case 140 may be coupled to a rear end of the top case 150.

The module case 100 may include a vent case 110. The vent case 110 may form one side of the module case 100. A front end of the vent case 110 may be coupled to one side of the front case 130. A rear end of the vent case 110 may be coupled to one side of the rear case 140. An upper end of the vent case 110 may be coupled to one side of the top case 150. A lower end of the vent case 110 may be coupled to one side of the bottom case 160.

The vent case 110 may include a vent case body 111. The vent case body 111 may form a skeleton or frame of the vent case 110. The vent case body 111 may form an overall shape of the vent case 110. The vent case body 111 may form a plate shape as a whole.

The vent case 110 may include a vent opening 112. The vent opening 112 may be an opening formed in the vent case body 111. In some implementations, the vent case 110 may include a plurality of vent openings 112. The vent openings 112 may communicate with the inside and the outside of the module case 100. When a fire occurs in the battery cell (not shown) positioned inside the module case 100, gas and/or dust caused by the fire may be discharged to the outside of the module case 100 through the vent openings 112.

The vent case 110 may include a duct coupling part 113. The duct coupling part 113 may be formed or coupled to the vent case body 111. The duct coupling part 113 may be coupled to a duct. When a fire occurs in the battery cell (not shown) positioned inside the module case 100, gas and/or dust caused by the fire may pass through the vent opening 112 and move to the duct.

That is, even if a fire occurs inside the battery module 10 (see FIG. 2), substances generated by the fire may move to a separate space through the vent opening 112. Here, the term "separate space" may be used to indicate a space (e.g., empty space) that is formed by components coupled to the duct coupling part 113.

The module case 100 may include a side case 120. The side case 120 may form another side of the module case 100. A front end of the side case 120 may be coupled to another side of the front case 130. A rear end of the side case 120 may be coupled to another side of the rear case 140. An upper end of the side case 120 may be coupled to another side of the top case 150. A lower end of the side case 120 may be coupled to another side of the bottom case 160. The side case 120 may face the vent case 110.

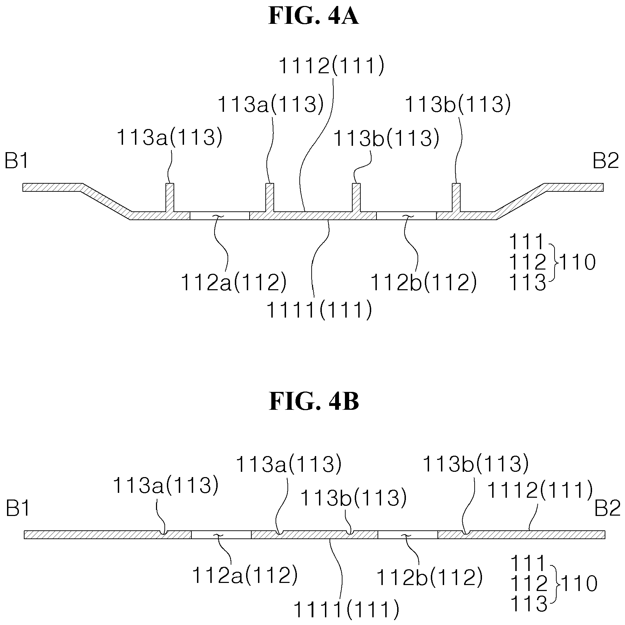

FIG. 4A is a cross-sectional view of a vent case taken along B1-B2 of FIG. 3 and illustrates a protruding duct coupling part. FIG. 4B is a cross-sectional view of a vent case taken along B 1-B2 of FIG. 3 and illustrates a concave duct coupling part.

Referring to FIGS. 4A and 4B, the bent case body 111 may form both surfaces. For example, the vent case body 111 may include a vent case inner surface 1111 forming an inner surface of the vent case 110. The vent case inner surface 1111 may face the battery cell (not shown) of the battery module 10 (see FIG. 2).

For example, the vent case body 111 may include a vent case outer surface 1112 forming an outer surface of the vent case 110. The vent case outer surface 1112 may form a portion of an outer surface of the battery module 10 (see FIG. 2).

For example, as illustrated in FIG. 4B, the bent case body 111 may form a plate shape as a whole. For example, as illustrated in FIG. 4A, the bent case body 111 may form a curved (or bent) plate shape.

For example, as illustrated in FIG. 4A, the bent case body 111 may form a concave shape on the vent case outer surface 1112. In other words, the bent case body 111 may form a concave shape at the outside of the module case 100 (see FIG. 2).

For example, as illustrated in FIG. 4A, the bent case body 111 may form a convex shape on the vent case inner surface 1111. In other words, the bent case body 111 may form a convex shape at the inside of the module case 100 (see FIG. 2).

The vent case 110 may include the vent opening 112. The vent opening 112 may be an opening formed in the vent case body 111. The vent opening 112 may be formed or positioned in one area of the vent case body 111.

In some implementations, the vent case 110 may include a plurality of vent openings 112. The plurality of vent openings 112 may be arranged in a row in a vertical direction. For example, the vent opening 112 may include an upper vent opening 112a and a lower vent opening 112b. The upper vent opening 112a may be positioned on the lower vent opening 112b.

Referring to FIG. 4A, when the bent case body 111 forms a convex area toward the inside of the module case 100 (see FIG. 2), the vent opening 112 may be formed in an inward convex portion in an area of the bent case body 111. In other words, when the bent case body 111 forms a concave area toward the outside of the module case 100 (see FIG. 2), the vent opening 112 may be formed in an outward concave portion in the area of the bent case body 111.

The vent case 110 may include the duct coupling part 113. The duct coupling part 113 may be formed, positioned, or coupled to the vent case outer surface 1112. The duct coupling part 113 may be adjacent to the vent opening 112.

Referring to FIG. 4A, the duct coupling part 113 may protrude from the vent case outer surface 1112. Referring to FIG. 4B, the duct coupling part 113 may be recessed in the vent case outer surface 1112 and formed concavely.

Referring to FIGS. 4A and 4B, when a duct is coupled to the duct coupling part 113, substances (e.g., gas or dust, etc.) positioned inside the module case 100 (see FIG. 2) may pass through the duct opening 112 and enter the duct.

In some implementations, the vent case 110 may include a plurality of duct coupling parts 113. The plurality of duct coupling parts 113 may be arranged in a row in a vertical direction. For example, the duct coupling part 113 may include an upper duct coupling part 113a and a lower duct coupling part 113b. The upper duct coupling part 113a may be positioned on the lower duct coupling part 113b. The upper duct coupling part 113a may be adjacent to the upper vent opening 112a. The lower duct coupling part 113b may be adj acent to the lower vent opening 112b.

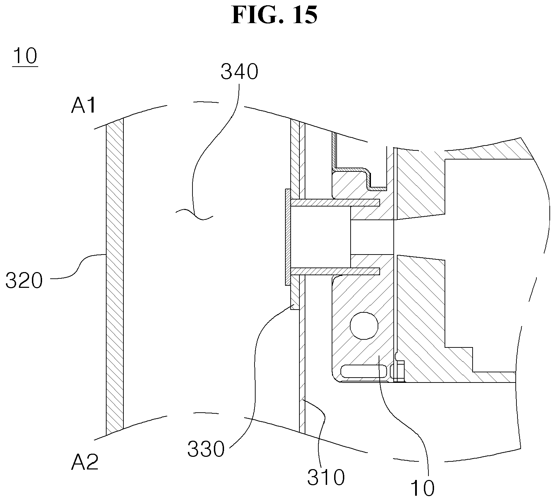

Referring to FIGS. 1 to 4B, the battery module 10 may be accommodated in the enclosure 30. For example, the vent case 110 may face one side of the enclosure 30. For example, the vent case 110 may face an inner wall 310 (see FIG. 15) of the enclosure 30.

The duct may be coupled to the duct coupling part 113. One end of the duct may be connected to the duct coupling part 113. The other end of the duct may be connected to the inner wall 310 (see FIG. 15) of the enclosure 30. When a fire occurs in the battery cell (not shown) of the battery module 10, substances (e.g., flame, gas, dust, etc.) generated by the fire may enter the duct through the vent opening 112.

At least a portion of the substances entering the duct may enter a space between the inner wall 310 (see FIG. 15) and an outer wall 320 (see FIG. 15) of the enclosure 30. The substances entering the space between the inner wall 310 (see FIG. 15) and the outer wall 320 (see FIG. 15) of the enclosure 30 may be discharged to the outside of the energy storage system 1 by a fan.

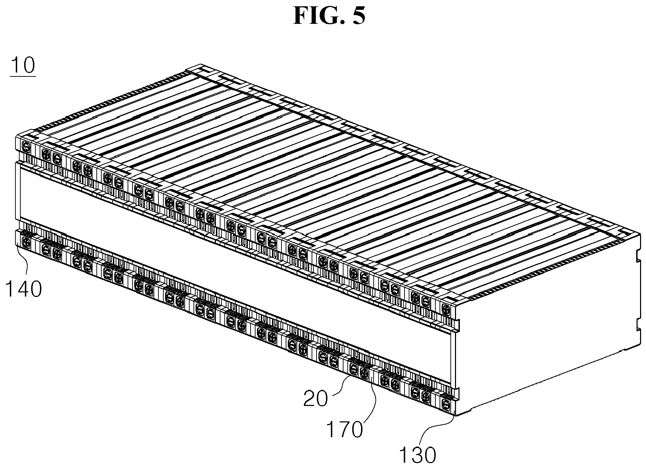

FIG. 5 illustrates an example of a battery module including a plurality of sub-battery modules based on an embodiment of the disclosed technology.

Referring to FIG. 5, the battery module 10 may include a plurality of sub-battery modules 20. The plurality of sub-battery modules 20 may be arranged in one direction. For example, the plurality of sub-battery modules 20 may be disposed in a front-back direction. Each of the plurality of sub-battery modules 20 may include at least one battery cell (not shown). For example, each of the plurality of sub-battery modules 20 may include two battery cells (not shown).

The battery module 10 may include the front case 130. The front case 130 may be positioned in front of the plurality of sub-battery modules 20. The front case 130 may form a front face of the battery module 10.

The battery module 10 may include the rear case 140. The rear case 140 may be positioned behind the plurality of sub-battery modules 20. The rear case 140 may form a rear face of the battery module 10.

The plurality of sub-battery modules 20 may be positioned between the front case 130 and the rear case 140. The battery module 10 may include a spacer 170. The spacer 170 may be disposed between two adjacent sub-battery modules 20. At least one spacer 170 may be disposed between the front case 130 and the rear case 140.

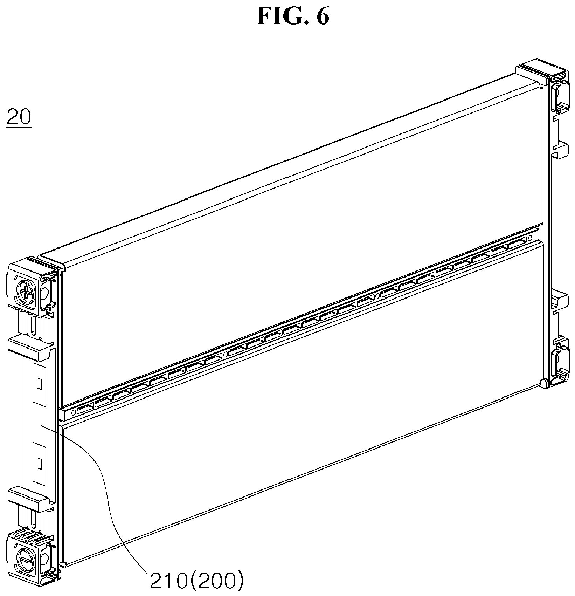

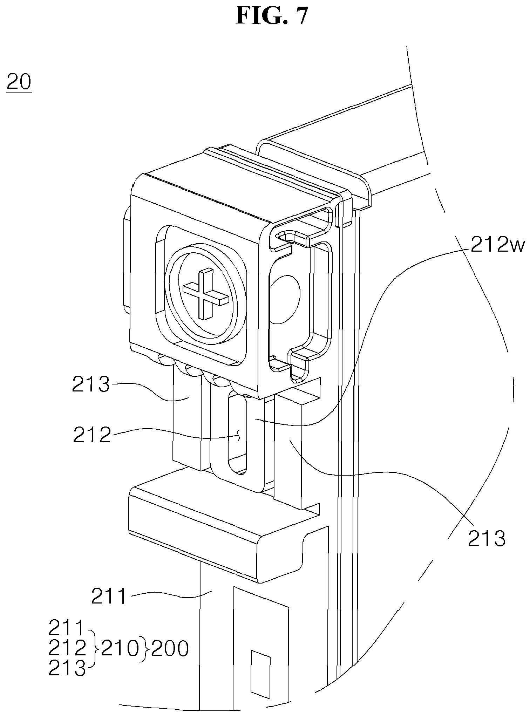

FIG. 6 illustrates an example of a sub-battery module. FIG. 7 illustrates a portion of a sub-battery module illustrated in FIG. 6.

Referring to FIGS. 6 and 7, the sub-battery module 20 may include a sub-module case 200. The sub-module case 200 may form an exterior appearance of the sub-battery module 20. The sub-module case 200 may accommodate at least one battery cell (not shown). At least one battery cell (not shown) accommodated in the sub-module case 200 may be a secondary battery capable of charging and discharging.

The sub-module case 200 may include a sub-vent case 210. The sub-vent case 210 may form one side of the sub-module case 200. For example, the sub-vent case 210 may face one surface of the enclosure 30 (see FIG. 1). For example, the sub-vent case 210 may face the inner wall 310 (see FIG. 15) of the enclosure 30 (see FIG. 1).

The sub-vent case 210 may include a sub-vent case body 211. The sub-vent case body 211 may form an overall shape of the sub-vent case 210. For example, the sub-vent case body 211 may face the inner wall 310 (see FIG. 15) of the enclosure 30 (see FIG. 1).

The sub-vent case 210 may include a sub-vent hole 212. The sub-vent hole 212 may be at least a portion of a hole formed in the sub-vent case body 211. The sub-vent hole 212 may provide a ventilation path to communicate with the inside and the outside of the sub-module case 200 so as to transfer undesired substances out of the sub-module case 200.

The sub-vent case 210 may include a sub-vent wall 212w. The sub-vent wall 212w may protrude from an outer surface of the sub-vent case body 211. The sub-vent wall 212w may surround the sub-vent hole 212.

The sub-vent wall 212w may include a hollow. The hollow formed in the sub-vent wall 212w may be open in a protruding direction of the sub-vent wall 212w from the sub-vent case body 211. The hollow formed in the sub-vent wall 212w may be a portion of the sub-vent hole 212.

The sub-vent case 210 may include a sub-duct coupling part 213. The sub-duct coupling part 213 may be formed on the sub-vent case body 211. For example, the sub-duct coupling part 213 may protrude from the outer surface of the sub-vent case body 211. The sub-duct coupling part 213 may be adjacent to the sub-vent hole 212.

The sub-duct coupling part 213 may be adjacent to the sub-vent wall 212w. At least a portion of the sub-duct coupling part 213 may be spaced apart from the sub-vent wall 212w. For example, an end of the sub-duct coupling part 213 and the sub-vent wall 212w may be spaced apart from each other. For example, a space or a gap may be formed between the end of the sub-duct coupling part 213 and the sub-vent wall 212w.

The duct may be coupled to the sub-duct coupling part 213. For example, after the battery module 10 (see FIG. 5) is loaded into the enclosure 30 (see FIG. 1), the duct may be coupled to the sub-duct coupling part 213. One end of the duct may be connected to the sub-duct coupling part 213. The other end of the duct may be connected to the inner wall 310 (see FIG. 15) of the enclosure 30 (see FIG. 1).

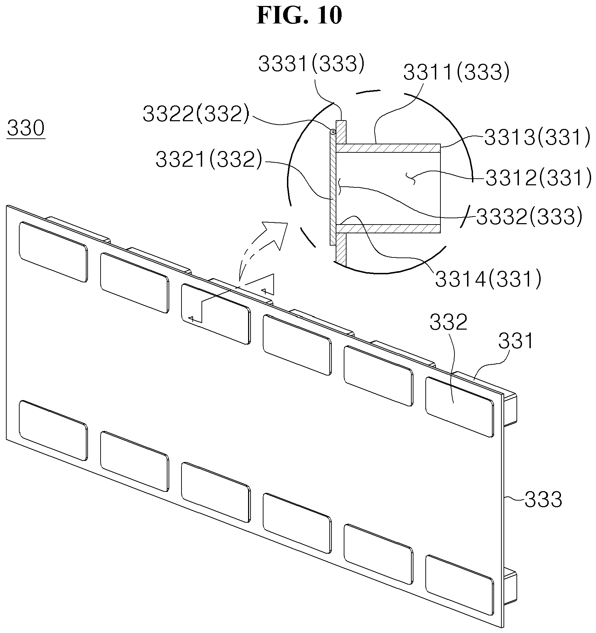

For example, a duct 331 (see FIG. 10) may be coupled to the sub-duct coupling part 213. For example, the duct 331 (see FIG. 10) may be interposed between the sub-duct coupling part 213 and the sub-vent wall 212w. For example, an end of the duct 331 (see FIG. 10) may be inserted between the sub-duct coupling part 213 and the sub-vent wall 212w.

When a fire occurs in the battery cell (not shown) of the sub-battery module 20, substances (e.g., flame, gas, dust, etc.) generated by the fire may enter the duct through the sub-vent hole 212.

At least part of the substances entering the duct may enter a space between the inner wall 310 (see FIG. 15) and the outer wall 320 (see FIG. 15) of the enclosure 30 (see FIG. 1). The substances entering the space between the inner wall 310 (see FIG. 15) and the outer wall 320 (see FIG. 15) of the enclosure 30 (see FIG. 1) may be discharged to the outside of the energy storage system 1 (see FIG. 1) by a fan. Therefore, the above example of a duct structure and the sub-vent hole can be advantageously used to provide a ventilation path to transfer undesired substances inside the energy storage system 1 to the outside.

Referring to FIGS. 1 to 7, the vent portions 112 and 212 may indicate at least one of the vent opening 112 or the sub-vent hole 212. The coupling parts 113 and 213 may indicate at least one of the duct coupling part 113 or the sub-duct coupling portion 213. The cases 100 and 200 may indicate at least one of the module case 100 or the sub-module case 200. The first cases 110 and 210 may indicate at least one of the vent case 110 or the sub-vent case 210. The first case bodies 111 and 211 may indicate at least one of the vent case body 111 or the sub-vent case body 211.

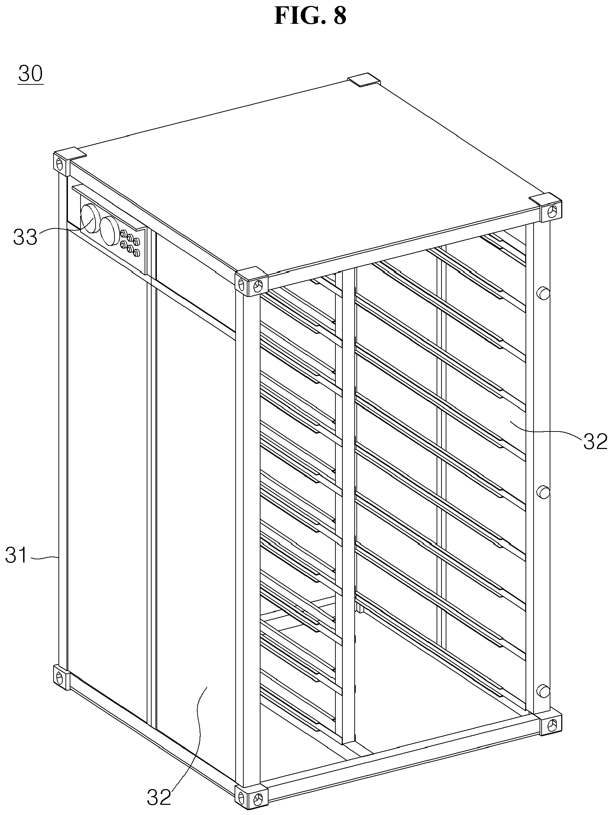

FIG. 8 illustrates an example of a battery enclosure based on an embodiment of the disclosed technology. For convenience of description, a front part of the enclosure may be omitted in FIG. 8.

Referring to FIG. 8, the enclosure 30 may include an enclosure frame 31. The enclosure frame 31 may form a skeleton or frame of the enclosure 30. The enclosure frame 31 may load the battery module 10 (see FIGS. 2 and 5).

The enclosure 30 may include a wall assembly 32. The wall assembly 32 may be coupled to the enclosure frame 31. The wall assembly 32 may form a face of the enclosure 30.

The wall assembly 32 may form a wall of the enclosure 30. The wall assembly 32 may face the battery module 10 (see FIGS. 2 and 5). For example, the wall assembly 32 may include the inner wall 310 (see FIG. 15) and the outer wall 320 (see FIG. 15).

The inner wall 310 (see FIG. 15) of the wall assembly 32 may face the battery module 10 (see FIGS. 2 and 5). The outer wall 320 (see FIG. 15) of the wall assembly 32 may form an outer surface of the enclosure 30. The inner wall 310 (see FIG. 15) and the outer wall 320 (see FIG. 15) of the wall assembly 32 may be spaced apart from each other. The inner wall 310 (see FIG. 15) and the outer wall 320 (see FIG. 15) of the wall assembly 32 may form a space in which substances (e.g., gas, dust, etc.) can flow.

The enclosure 30 may include a fan assembly 33. The fan assembly 33 may be connected or coupled to the wall assembly 32. The fan assembly 33 may communicate with a space formed by the inner wall 310 (see FIG. 15) and the outer wall 320 (see FIG. 15) of the wall assembly 32. The space formed by the inner wall 310 (see FIG. 15) and the outer wall 320 (see FIG. 15) of the wall assembly 32 may be referred to as a "wall space." The wall space may indicate a flow space 340 (see FIG. 15).

The fan assembly 33 may make an atmospheric pressure of the wall space lower than an atmospheric pressure outside the enclosure 30. In other words, the fan assembly 33 may discharge substances (e.g., flame, dust, etc.) positioned in the wall space to the outside of the enclosure 30. The fan assembly 33 may include a fan.

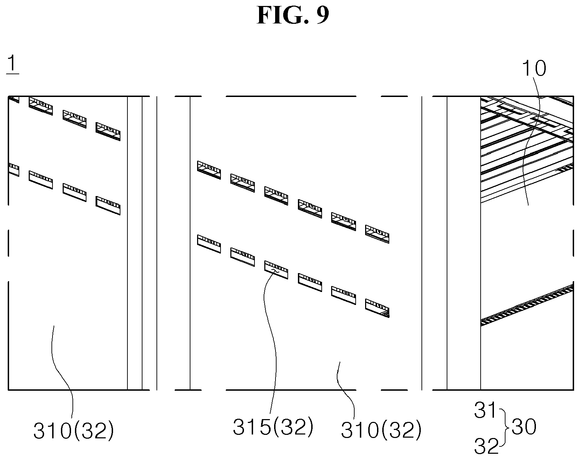

FIG. 9 illustrates an example of a battery module loaded into an enclosure. For convenience of description, a portion of the energy storage system 1 (see FIG. 1) may be omitted in FIG. 9.

Referring to FIG. 9, in a state in which the outer wall 320 (see FIG. 15) is not coupled to the enclosure frame 31, the battery module 10 may be loaded into the enclosure 30. For example, the battery module 10 loaded into the enclosure 30 may be the battery module 10 illustrated in FIG. 2. For another example, the battery module 10 loaded into the enclosure 30 may be the battery module 10 illustrated in FIG. 5.

The wall assembly 32 may include the inner wall 310. The inner wall 310 may be coupled or connected to the enclosure frame 31. The inner wall 310 may face the inside of the enclosure 30.

When the battery module 10 is loaded into the enclosure 30, the inner wall 310 may face the battery module 10. For example, when the battery module 10 is loaded into the enclosure 30, the inner wall 310 may face the vent case 110 (see FIG. 3) of the battery module 10. For example, when the battery module 10 is loaded into the enclosure 30, the inner wall 310 may face the sub-vent case 210 (see FIG. 6) of the battery module 10.

The wall assembly 32 may include an inner wall opening 315. The inner wall opening 315 may be an opening formed in the inner wall 310. For example, the inner wall opening 315 may face the vent opening 112 (see FIG. 3). For another example, the inner wall opening 315 may face the sub-vent hole 212 (see FIG. 7).

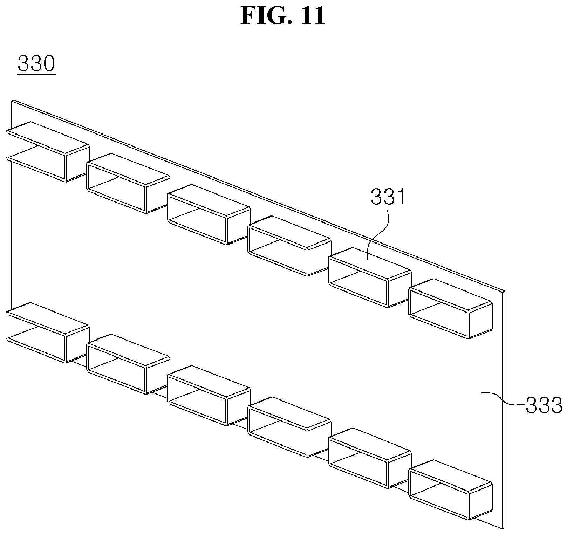

FIGS. 10 and 11 illustrate a duct module based on an embodiment of the disclosed technology when viewed at different angles.

Referring to FIGS. 10 and 11, the wall assembly 32 (see FIG. 8) may include a duct module 330. The duct module 330 may be coupled to the inner wall 310 (see FIG. 9).

The duct module 330 may include a duct 331. A plurality of ducts 331 may be provided. The duct 331 may include a duct body 3311 having a shape extending from one end toward the other end.

The duct body 3311 may form a hollow therein. For example, the duct 331 may include a duct hollow 3312. The duct hollow 3312 may be a hollow formed in the duct body 3311.

The duct 331 may include a first duct end 3313. The first duct end 3313 may be one end of the duct body 3311. The duct 331 may include a second duct end 3314. The second duct end 3314 may be other end of the duct body 3311.

The first duct end 3313 and the second duct end 3314 may include openings. For example, the first duct end 3313 may communicate with the duct hollow 3312. For example, the second duct end 3314 may communicate with the duct hollow 3312.

The duct 331 may be coupled or connected to the battery module 10 (see FIG. 9). For example, the first duct end 3313 may be coupled or connected to the duct coupling part 113 (see FIG. 3) of the battery module 10 (see FIG. 2). The first duct end 3313 may communicate with the vent opening 112 (see FIG. 3).

The duct 331 may be coupled or connected to the battery module 10 (see FIG. 5). For example, the first duct end 3313 may be coupled or connected to the sub-duct coupling part 213 (see FIG. 7) of the battery module 10 (see FIG. 5). The first duct end 3313 may communicate with the sub-vent hole 212 (see FIG. 7).

The duct 331 may be connected to the inner wall 310 (see FIG. 9). For example, the duct 331 may be positioned in the inner wall opening 315 (see FIG. 9). For example, the second duct end 3314 may be connected to the inner wall opening 315 (see FIG. 9). For example, the second duct end 3314 may communicate with the wall space.

The duct module 330 may include a cap 332. The cap 332 may be connected or coupled to the duct 331. The cap 332 may be used to cover the second duct end 3314 of the duct 331.

The cap 332 may be used to allow or block access to the second duct end 3314 in one direction. For example, the cap 332 may allow a substance positioned inside the duct 331 to be discharged to the outside of the duct 331 through the second duct end 3314. For example, the cap 332 may prevent a substance positioned outside the duct 331 from entering the duct hollow 3312 through the second duct end 3314. In some implementations, the cap 332 may be a check valve.

The cap 332 may include a cap body 3321. The cap body 3321 may be used to allow or block access to the second duct end 3314. The cap body 3321 may form an overall shape of the cap 332.

The cap 332 may include a cap connection part 3322. The cap connection part 3322 may be formed or coupled to one side of the cap 332. The cap connection part 3322 may be coupled or connected to the second duct end 3314. The cap connection part 3322 may be coupled or connected to a duct frame 333. The cap body 3321 may rotate with respect to the second duct end 3314 through the cap connection part 3322. The cap connection part 3322 may be positioned or formed at an upper end of the cap body 3321.

The duct module 330 may include the duct frame 333. The duct frame 333 may be coupled or connected to at least one duct 331. The duct frame 333 may form a plate shape. An opening may be formed in the duct frame 333. The duct 331 may be connected to the opening formed in the duct frame 333.

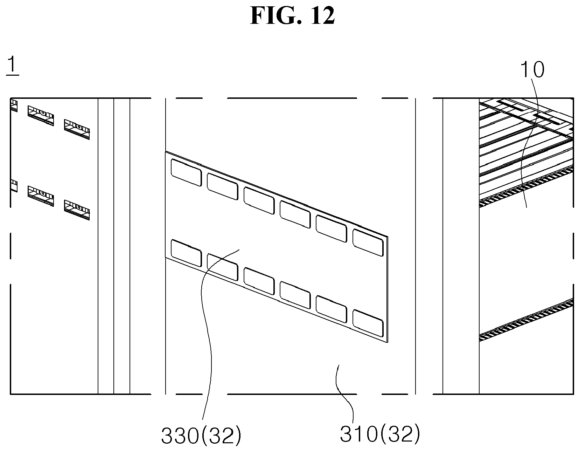

FIG. 12 illustrates an example of a duct module coupled to an inner wall.

Referring to FIG. 12, the duct module 330 may be coupled to the inner wall 310. For example, before the outer wall 320 (see FIG. 15) is coupled to the enclosure frame 31 (see FIG. 8), the duct module 330 may move from the outside of the enclosure 30 (see FIG. 8) to the inner wall 310 and may be coupled to the inner wall 310. For example, the duct 331 (see FIGS. 10 and 11) of the duct module 330 may be inserted into the inner wall opening 315 (see FIG. 9) formed in the inner wall 310.

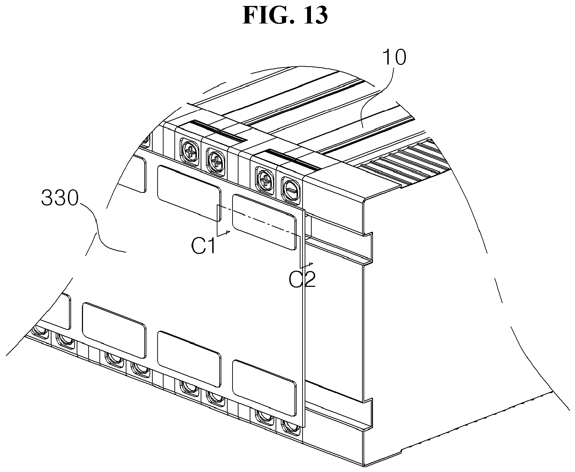

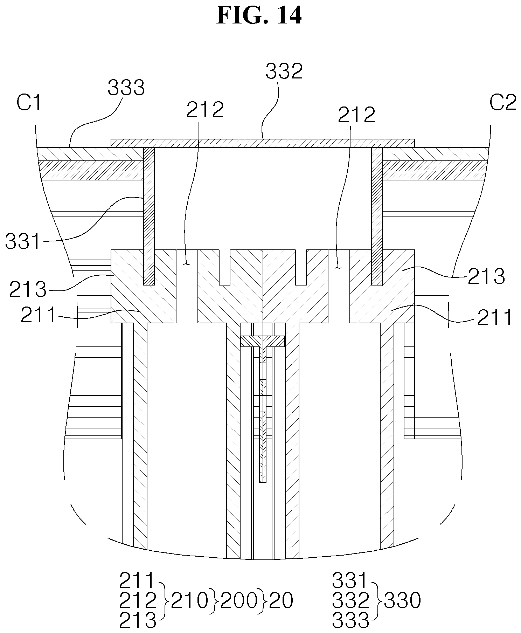

FIG. 13 illustrates an example of a duct module coupled to a battery module. FIG. 14 is a cross-sectional view of a duct module and a battery module taken along C1-C2 of FIG. 13.

Referring to FIGS. 13 and 14, the duct module 330 may be coupled to the battery module 10. The duct 331 inserted into the inner wall opening 315 (see FIG. 9) may be coupled to the battery module 10 (see FIGS. 2 and 5).

For example, the first duct end 3313 (see FIG. 10) of the duct 331 may be coupled or connected to the duct coupling part 113 (see FIG. 3). For example, the first duct end 3313 (see FIG. 10) of the duct 331 may be coupled or connected to the sub-duct coupling part 213.

The duct 331 may communicate with the battery module 10 (see FIGS. 2 and 5). For example, the duct hollow 3312 (see FIG. 10) of the duct 331 may communicate with the vent opening 112 (see FIG. 3) or the sub-vent hole 212.

FIG. 15 is a cross-sectional view of an energy storage system taken along A1-A2 of FIG. 1.

Referring to FIGS. 1 to 15, after the duct module 330 is coupled to the battery module 10, the outer wall 320 may be coupled to the enclosure frame 31. The outer wall 320 may face an outer surface of the inner wall 310. The outer wall 320 may be spaced apart from the inner wall 310.

The inner wall 310 and the outer wall 320 may form the flow space 340. The flow space 340 may refer to a space between the inner wall 310 and the outer wall 320. The wall assembly 32 may include the flow space 340.

When a fire occurs in the battery cell positioned inside the battery module 10, substances (e.g., flame, gas, dust, etc.) caused by the fire may pass through at least one of the vent opening 112 or the sub-vent hole 212 and may enter the duct hollow 3312.

The substances (e.g., flame, gas, dust, etc.) entering the duct hollow 3312 may push the cap 332 and enter the flow space 340. An atmospheric pressure of the flow space 340 may be lower than an external atmospheric pressure of the energy storage system 1. Air flow in the flow space 340 may be directed toward the fan assembly 33. The substances (e.g., flame, gas, dust, etc.) entering the flow space 340 may flow in the flow space 340 and enter the fan assembly 33. The substances (e.g., flame, gas, dust, etc.) entering the fan assembly 33 may be discharged to the outside of the energy storage system 1.

The disclosed technology can be implemented in rechargeable secondary batteries that are widely used in battery-powered devices or systems, including, e.g., digital cameras, mobile phones, notebook computers, hybrid vehicles, electric vehicles, uninterruptible power supplies, battery storage power stations, and others including battery power storage for solar panels, wind power generators and other green tech power generators. Specifically, the disclosed technology can be implemented in some embodiments to provide improved electrochemical devices such as a battery used in various power sources and power supplies, thereby mitigating climate changes in connection with uses of power sources and power supplies. Lithium secondary batteries based on the disclosed technology can be used to address various adverse effects such as air pollution and greenhouse emissions by powering electric vehicles (EVs) as alternatives to vehicles using fossil fuel-based engines and by providing battery-based energy storage systems (ESSs) to store renewable energy such as solar power and wind power.

Only specific examples of implementations of certain embodiments are described. Variations, improvements and enhancements of the disclosed embodiments and other embodiments may be made based on the disclosure of this patent document.

## Claims

1. A battery module (10) comprising:
a plurality of sub-battery modules (20) arranged in a direction between forward and rearward sides of the battery module (10),
wherein each of the plurality of sub-battery modules (20) includes:
at least one battery cell; and
a sub-module case (200) structured to accommodate the at least one battery cell, the sub-module case (200) including a sub-vent case (210) forming a side of the sub-module case (200),
wherein the sub-module case (200) includes:
a sub-vent case body (211) forming the side of the sub-module case (200); and
a sub-vent hole (212) formed in the sub-vent case body (211) and structured to communicate with an inside and an outside of the sub-module case (200).

2. The battery module (10) of claim 1, wherein the sub-vent case (210) includes a sub-duct coupling part (213) configured to be coupled to a duct and formed on an outer surface of the sub-vent case body (211) and adjacent to the sub-vent hole (212),
preferably wherein the sub-vent case (210) protruding from an outer surface of the sub-vent case body (211) includes a sub-vent wall (212w), which surrounds the sub-vent hole (212),
more preferably wherein at least a portion of the sub-duct coupling part (213) is spaced apart from the sub-vent wall (212w).

3. The battery module (10) of claim 1 or 2, further comprising:
a front case (130) positioned in front of the plurality of sub-battery modules (20); and
a rear case (140) positioned behind the plurality of sub-battery modules (20).

4. A battery enclosure (30) comprising:
an enclosure frame (31) structured to include an accommodation space; and
a wall assembly (32) coupled to the enclosure frame (31) and structured to form a wall of the battery enclosure (30),
wherein the wall assembly (32) includes:
an inner wall (310) forming an inner surface of the wall assembly (32) and coupled to the enclosure frame (31);
an outer wall (320) forming an outer surface of the wall assembly (32) and coupled to the enclosure frame (31); and
a duct module (330) coupled to the inner wall (310) and including a duct (331) protruding toward the accommodation space.

5. The battery enclosure (30) of claim 4, wherein the enclosure frame (31) is configured to accommodate at least one battery module (10), and
wherein the duct (331) communicates with the at least one battery module (10).

6. The battery enclosure (30) of claim 4 or 5, wherein the wall assembly (32) further includes a flow space (340) formed between the inner wall (310) and the outer wall (320), and
wherein an atmospheric pressure of the flow space (340) is lower than an external atmospheric pressure of the battery enclosure (30).

7. The battery enclosure (30) of claim 6, further comprising:
a fan assembly (33) including a fan communicating with the flow space (340).

8. The battery enclosure (30) of any one of claims 4 to 7, wherein the duct (331) forms a shape extending from a first duct end (3313) toward a second duct end (3314),
wherein the duct (331) forms a duct hollow (3312) inside the duct (331),
wherein the first duct end (3313) is positioned in the accommodation space, and
wherein the second duct end (3314) is connected to the inner wall (310).

9. The battery enclosure (30) of claim 8, wherein the first duct end (3313) forms an opening and communicates with the duct hollow (3312) and the accommodation space.

10. The battery enclosure (30) of claim 8 or 9, wherein the wall assembly (32) further includes a flow space (340) formed between the inner wall (310) and the outer wall (320), and
wherein the second duct end (3314) forms an opening and communicates with the duct hollow (3312) and the accommodation space.

11. The battery enclosure (30) of any one of claims 8 to 10, wherein the second duct end (3314) forms an opening and communicates with the duct hollow (3312), and
wherein the duct module (330) further includes a cap (332) configured to cover the second duct end (3314).

12. An energy storage system (1) comprising:
a battery module (10) including at least one battery cell; and
a battery enclosure (30) structured to accommodate the battery module (10),
wherein the battery module (10) includes a case (100; 200) structured to include a first case (110; 210) forming a side of the battery module (10),
wherein the first case (110; 210) includes:
a first case body (111; 211) forming the side of the battery module (10); and
a vent portion (112; 212) formed in the first case body (111; 211),
wherein the battery enclosure (30) includes:
an enclosure frame (31) structured to accommodate the battery module (10); and
a wall assembly (32) forming a wall of the battery enclosure (30) and coupled to the enclosure frame (31),
wherein the wall assembly (32) includes a duct module (330) including a duct (331) structured to communicate with the vent portion (112; 212) and coupled to the first case (110; 210).

13. The energy storage system (1) of claim 12, wherein the first case (110; 210) further includes a coupling part (113; 213) adjacent to the vent portion (112; 212) and formed on the first case body (111; 211), and
wherein the coupling part (113; 213) is coupled to the duct (331).

14. The energy storage system (1) of claim 12 or 13, wherein the wall assembly (32) further includes:
an inner wall (310) facing the battery module (10); and
an outer wall (320) forming an outer surface of the battery enclosure (30),
wherein a flow space (340) is formed between the inner wall (310) and the outer wall (320)
preferably wherein the wall assembly (32) includes an inner wall opening (315), which faces the vent opening (112).

15. The energy storage system (1) of claim 14, wherein the duct (331) communicates with the flow space (340), and
wherein the duct module (330) further includes a cap (332) configured to cover the duct (331),
or wherein the duct (331) is inserted into the inner wall opening (315) formed in the inner wall (310).
